(19) Europäisches Patentamt
European Patent Office
Office européen des brevets

(11) **EP 4 498 537 A1**

(12) **EUROPEAN PATENT APPLICATION**

(43) Date of publication:
**29.01.2025 Bulletin 2025/05**

(51) International Patent Classification (IPC):
*H01S 5/00* $^{(2006.01)}$      *G02B 6/42* $^{(2006.01)}$
*G02B 27/09* $^{(2006.01)}$      *G02B 27/10* $^{(2006.01)}$
*G02B 27/18* $^{(2006.01)}$

(21) Application number: **24156479.8**

(22) Date of filing: **08.02.2024**

(52) Cooperative Patent Classification (CPC):
**G02B 27/0922; G02B 6/4206; G02B 27/0927;
G02B 27/1006; G02B 27/126; G02B 27/18;
H01S 5/005; H01S 5/02251**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.07.2023 CN 202310916695**

(71) Applicant: **Delta Electronics, Inc.
Taoyuan City 333 (TW)**

(72) Inventor: **HSU, Ming-Yo
333 Taoyuan City (TW)**

(74) Representative: **Porta & Consulenti Associati
S.p.A.
Via Vittoria Colonna, 4
20149 Milano (IT)**

(54) **LASER LIGHT SOURCE MODULE AND PROJECTION APPARATUS HAVING THE SAME**

(57) A laser light source module includes a laser chip, a wedge structure, a plano-convex lens, and an optical fiber. The laser chip is configured to emit a first light beam and a second light beam. The wedge structure is configured to refract the first light beam and the second light beam into a third light beam and make the first light beam and the second light beam overlap each other. The wedge structure is located between the laser chip and the plano-convex lens. The plano-convex lens is located between the wedge structure and the optical fiber.

Fig. 3

## Description

## BACKGROUND

Field of Invention

The present invention relates to a laser light source module and projection apparatus.

Description of Related Art

Common light sources of projector include UHP lamp, LED, laser phosphor, and pure laser. The pure laser has advantages such as long life-span, high brightness, and good color saturation. Due to the breakthrough of high power semiconductor laser technology, pure laser becomes a dominant laser light source.

In RGB semiconductor laser technology, the red laser has lower power due to wavelength property and development level. If the number of red light source is increased for enhancing red laser output power, the optical design becomes complicated and the light receiving area becomes larger, which increases the production cost.

Accordingly, it is still a development direction for the industry to provide a laser light source module that can solve the problems mentioned above.

## SUMMARY

The invention provides a laser light source module.

In one embodiment, the laser light source module includes a laser chip, a wedge structure, a plano-convex lens, and an optical fiber. The laser chip is configured to emit a first light beam and a second light beam. The wedge structure is configured to refract the first light beam and the second light beam into a third light beam and make the first light beam and the second light beam overlap each other. The wedge structure is located between the laser chip and the plano-convex lens. The plano-convex lens is located between the wedge structure and the optical fiber.

In one embodiment, the laser chip is a red semiconductor laser chip of multiple resonant cavities.

In one embodiment, the optical fiber includes a light receiving surface, the plano-convex lens is configured to focus the third light beam from the wedge structure to form a fifth light beam, and the light receiving surface is configured to receive the fifth light beam.

In one embodiment, the laser chip includes a light-emitting surface, a first resonant cavity, and a second resonant cavity, the first resonant cavity emits the first light, the second resonant cavity emits the second light, the wedge structure includes a first plane, a first inclined surface, and a second inclined surface, the first plane faces the light-emitting surface of the laser chip, the first inclined surface and the second inclined surface face the plano-convex lens and are opposite to the first plane, and the first light beam and the second light beam pass through the first inclined surface and the second inclined surface, respectively.

In one embodiment, the laser chip further includes a third resonant cavity located between the first resonant cavity and the second resonant cavity, the third resonant cavity emits a fourth light beam, the wedge structure includes a second plane, the second plane connects the first inclined surface and the second inclined surface and is opposite to the first plane, the fourth light beam passes through the second plane, and the first inclined surface and the second inclined surface of the wedge structure are configured to refract the first light beam and the second light beam towards the fourth light beam and make the first light beam and the second light beam to overlap each other.

In one embodiment, a number of the at least one laser chip is plural, a number of the at least one wedge structure is plural, the wedge structures correspond to the laser chips respectively, the laser chips form at least one laser array, and the wedge structures form at least one wedge array.

In one embodiment, the wedge structures of the wedge array are connected together.

In one embodiment, each one of the laser chips includes the first resonant cavity and the second resonant cavity arranged along a first direction, the first inclined surfaces and the second inclined surfaces of the wedge structures are alternately arranged along the first direction, each one of the first inclined surfaces of the wedge structures is configured to refract more than one of the first light beams, and each one of the second inclined surfaces of the wedge structures is configured to refract more than one of the second light beams.

In one embodiment, the first inclined surface and the second inclined surface of each one of the wedge structures have an angle therebetween, and the angles of the wedge structures are the same.

Another aspect of the present disclosure is a projection apparatus.

In one embodiment, the projection apparatus includes a laser light source module and a projection module. The projection module connects the laser light source module. The laser light source module includes a first laser chip, a second laser chip, a third laser chip, a wedge structure, and a plano-convex lens. The first laser chip is configured to emit a first light beam and a second light beam. The wedge structure is configured to refract the first light beam and the second light beam into a third light beam and make the first light beam and the second light beam overlap each other. The wedge structure is located between the first laser chip and the plano-convex lens.

In one embodiment, the laser light source module further includes an optical fiber, and the plano-convex lens is located between the wedge structure and the optical fiber.

In one embodiment, the first laser chip, the second laser chip, and the third laser chip are semiconductor lasers and are configured to emit laser lights with different wavelengths.

In one embodiment, the first laser chip is a semiconductor laser chip of multiple resonant cavities, and the second laser chip and the third laser chip are semiconductor laser chips of single resonant cavity.

In one embodiment, the first laser chip is a red semiconductor laser chip, and the first laser chip includes a light-emitting surface, a first resonant cavity, and a second resonant cavity, the first resonant cavity emits the first light beam, the second resonant cavity emits the second light beam, the wedge structure includes a first plane, a first inclined surface, and a second inclined surface, the first plane faces the light-emitting surface of the first laser chip, the first inclined surface and the second inclined surface face the plano-convex lens and are opposite to the first plane, and the first light beam and the second light beam pass through the first inclined surface and the second inclined surface, respectively.

In one embodiment, the first laser chip further includes a third resonant cavity located between the first resonant cavity and the second resonant cavity, the third resonant cavity emits a fourth light beam, the wedge structure further includes a second plane, the second plane connects the first inclined surface and the second inclined surface and are opposite to the first plane, the fourth light beam passes through the second plane, and the first inclined surface and the second inclined surface of the wedge structure are configured to respectively refract the first light beam and the second light beam towards the fourth light beam and make the first light beam and the second light beam overlap each other.

In one embodiment, a number of the at least one first laser chip is plural, a number of the at least one wedge structure is plural, the wedge structures correspond to the first laser chips respectively, the first laser chips form at least one laser array, and the wedge structures form at least one wedge array.

In one embodiment, each one of the first laser chips includes the first resonant cavity and the second resonant cavity arranged along a first direction, the first inclined surfaces and the second inclined surfaces of the wedge structures are alternately arranged along the first direction, each one of the first inclined surfaces of the wedge structures are configured to refract more than one of the first light beams, and each one of the second inclined surfaces of the wedge structures are configured to refract more than one of the second light beams.

In one embodiment, the first inclined surface and the second inclined surface of each one of the wedge structures have an angle therebetween, and the angles of the wedge structures are the same.

In one embodiment, a number of the second laser chip is plural, the second laser chips form multiple second laser array, a number of the at least one third laser chip is plural, the third laser chips form a third laser array, the first laser chips are red semiconductor laser chips, the second laser chips are green semiconductor laser chips, and the third laser chips are blue semiconductor laser chips.

In the aforesaid embodiments, the wedge structure is configured to refract the light beams from the dual resonant cavities (or multiple resonant cavities) and make them overlap each other to form a single light beam. As such, the light receiving range of the light receiving surface of the optical fiber can be reduced to cut production cost. Such design enables the laser light source module be applied in a projection system having small light receiving area. The laser light source module can reduce light receiving area, cut production cost and remain the light receiving efficiency simultaneously.

## BRIEF DESCRIPTION OF THE DRAWINGS

The invention can be more fully understood by reading the following detailed description of the embodiment, with reference made to the accompanying drawings as follows:

Fig. 1 is a schematic of a projection apparatus according to one embodiment of the present disclosure.

Fig. 2 is a schematic of the laser light source module in Fig. 1.

Fig. 3 is a partial schematic of the laser light source module in Fig. 2.

Fig. 4 is an enlarged view of the first laser array in Fig. 3.

Fig. 5 is an enlarged view of the wedge array in Fig. 3.

Fig. 6 is a schematic of the first laser chip and the wedge structure according to one embodiment of the present disclosure.

Fig. 7 is a light path schematic of the light beam from the first laser chip passes through the wedge structure in Fig. 6.

Figs. 8A and 8B are simulated images of the first light beam and the second light beam of the first laser chip.

Figs. 9A and 9B are real images of the first light beam and the second light beam of the first laser chip.

Fig. 10 is a light schematic of the first laser array in Fig. 4.

Fig. 11 is a schematic of the first laser chip and the wedge structure according to another embodiment of the present disclosure.

Fig. 12 is a light path schematic of the light beam from the first laser chip passing through the wedge structure in Fig. 11.

Figs. 13A and 13B are schematics of laser light source module according to another embodiment of the present disclosure.

## DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

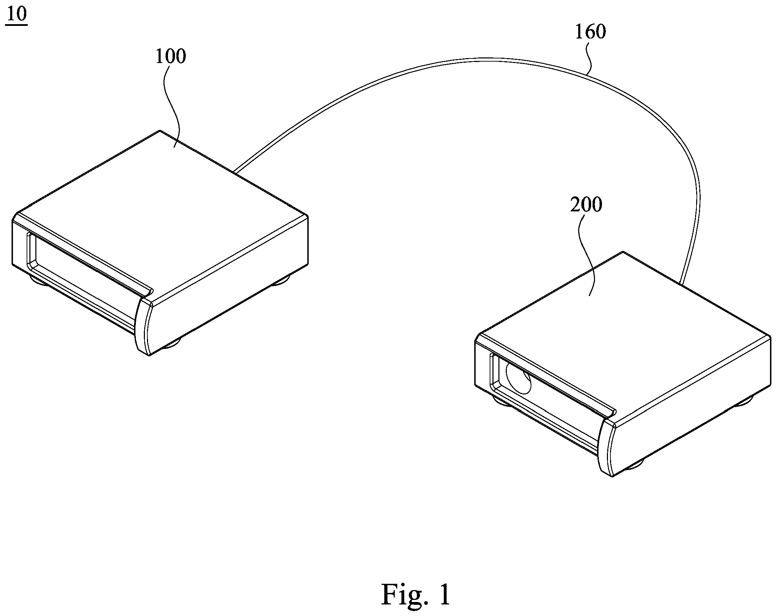

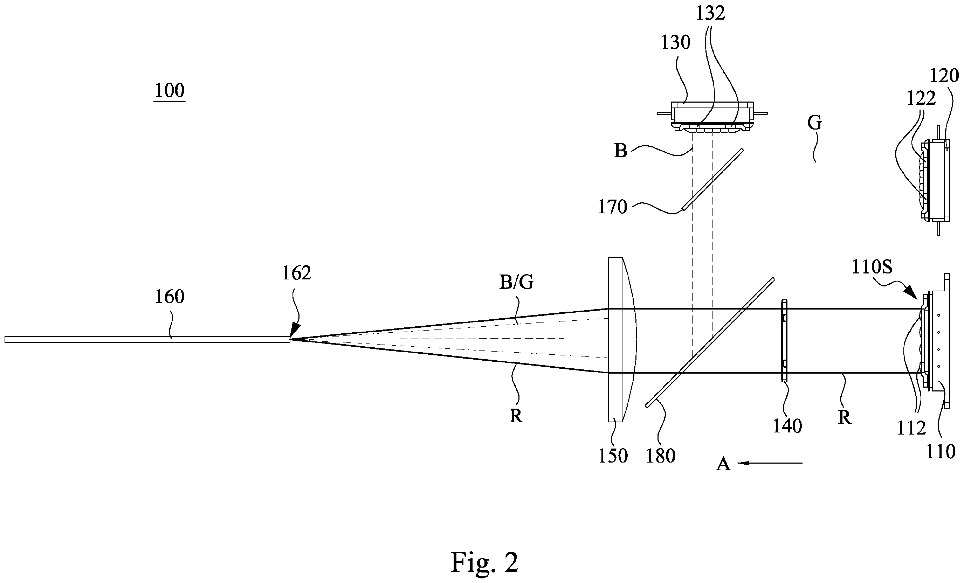

Fig. 1 is a schematic of a projection apparatus 10 according to one embodiment of the present disclosure. Fig. 2 is a schematic of the laser light source module 100 in Fig. 1. Reference is made to Fig. 1 and Fig. 2 simultaneously. The projection apparatus 10 includes a laser light source module 100 and a projection module 200. The laser light source module 100 includes a first laser array 110, a second laser array 120, a third laser array 130, a wedge array 140, a plano-convex lens 150, and an optical fiber 160. The laser light source module 100 connects the projection module 200 through the optical fiber 160 and to transmit light signal.

Reference is made to Fig. 2. In the present embodiment, the laser light source module 100 is a semiconductor laser. The first laser array 110 includes multiple first laser chips 112. The second laser array 120 includes multiple second laser chips 122. The third laser array 130 includes multiple third laser chips 132. The first laser chips 112, the second laser chips 122, and the third laser chips 132 are configured to emit laser lights with different wavelengths.

In the present embodiment, the first laser array 110 is a red semiconductor laser, the second laser array 120 is a green semiconductor laser, and the third laser array 130 is a blue semiconductor laser. The wedge array 140 is located between the first laser array 110 and the plano-convex lens 150. The wedge array 140 is configured to refract a red light R from the first laser array 110 and is accompanied by the plano-convex lens 150 to make the multiple laser light beams from the first laser chip 112 overlap each other so as to shrink the light spot and increase the red light R receiving efficiency of the optical fiber 160. As such, the output power of the red laser optical fiber is enhanced, and the power of the laser light source module 100 of different wavelengths can be balanced.

The laser light source module 100 further includes a first dichroic filter 170 and a second dichroic filter 180. The first dichroic filter 170 is located between the second laser array 120 and the third laser array 130. The first dichroic filter 170 reflects the green light G from the second laser array 120, and enables the transmittance of the blue light B from the third laser array 130. The second dichroic filter 180 is located between the wedge array 140 and the plano-convex lens 150. The second dichroic filter 180 reflects the green light G from the second laser array 120 and the blue light B from the third laser array 130, and enables the transmittance the red light R which is from the first laser array 110 and been refracted by the wedge array 140.

In the embodiment sown in Fig. 2. The relative positions of the first laser array 110, the second laser array 120, the third laser array 130, the first dichroic filter 170, and the second dichroic filter 180 are not limited as demonstrated herein, as long as the different laser lights can enter the optical fiber 160.

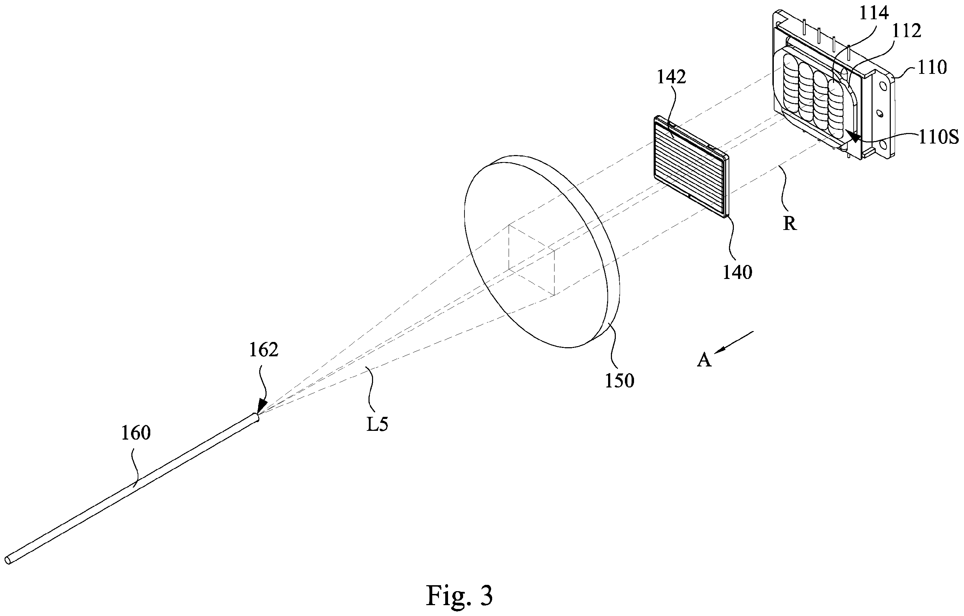

Fig. 3 is a partial schematic of the laser light source module 100 in Fig. 2. In the present embodiment, the first laser array 110, the wedge array 140, the plano-convex lens 150, and the optical fiber 160 are sequentially arranged along the direction of the optical axis A, but the present disclosure is not limited thereto. The plano-convex lens 150 is located between the wedge array 140 and the optical fiber 160. The first laser array 110 includes a light-emitting surface 110S. The light-emitting surface 110S faces the wedge array 140. In other words, a normal direction of the light-emitting surface 110S is parallel with the direction of the optical axis A. In other embodiment, the normal direction of the light-emitting surface 110S is not parallel with the direction of the optical axis A, and the light passed through the wedge array 140 can be transmit to the plano-convex lens 150 through other optical element. The optical fiber 160 has a light receiving surface 162. The light receiving surface 162 faces the plano-convex lens 150.

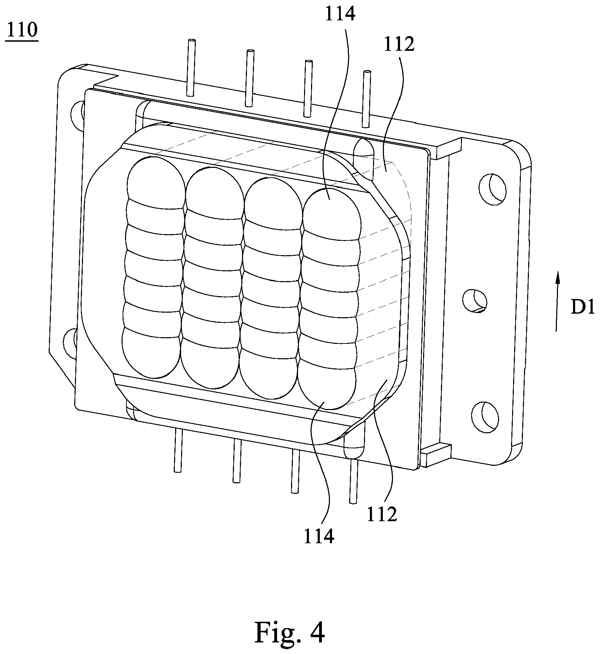

Fig. 4 is an enlarged view of the first laser array 110 in Fig. 3. The multiple first laser chips 112 form a first laser array 110 having seven rows and four columns, but the present disclosure is not limited thereto. The concrete structures of the first laser chip 112 will be described in the following paragraphs. As shown in Fig. 3 and Fig. 4, the first laser array 110 has a focusing lens 114 facing the wedge array 140, and each one of the first laser chip 112 corresponds to a single focusing lens 114. There are 28 focusing lens 114 in this embodiment which collectively form a lens array of the first laser array 110.

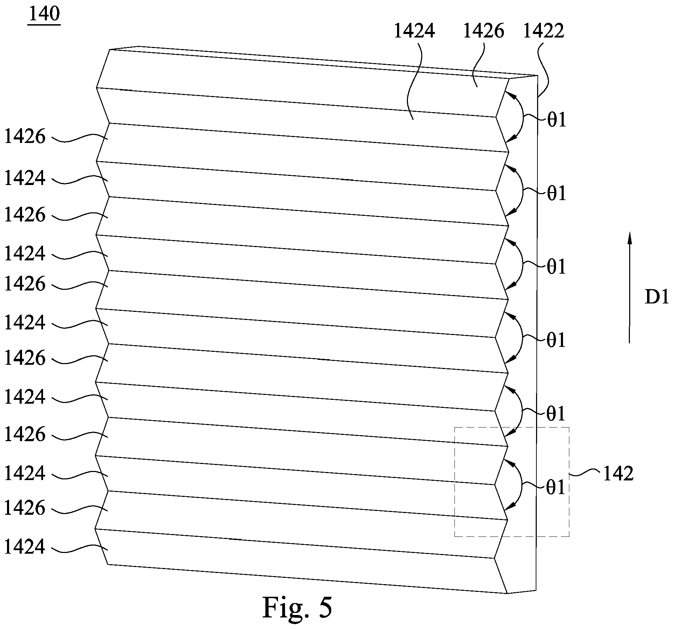

Fig. 5 is an enlarged view of the wedge array 140 in Fig. 3. The wedge array 140 includes multiple wedge structures 142 (the region labeled by the dashed frame). Each wedge structures 142 in Fig. 5 correspond to each first laser chips 112 in Fig. 4. Specifically, there are 28 wedge structures 142 which form a wedge array 140 having seven rows and four columns.

In the present embodiment, the wedge structures 142 that are located at the same row are connected together. In other words, the wedge array 140 of the present embodiment can be considered as seven strip shape wedge structures each formed by four wedge structures 142 at the same row, and then those seven strip shape wedge structures arranged along the first direction D1 are connected to form the wedge array 140.

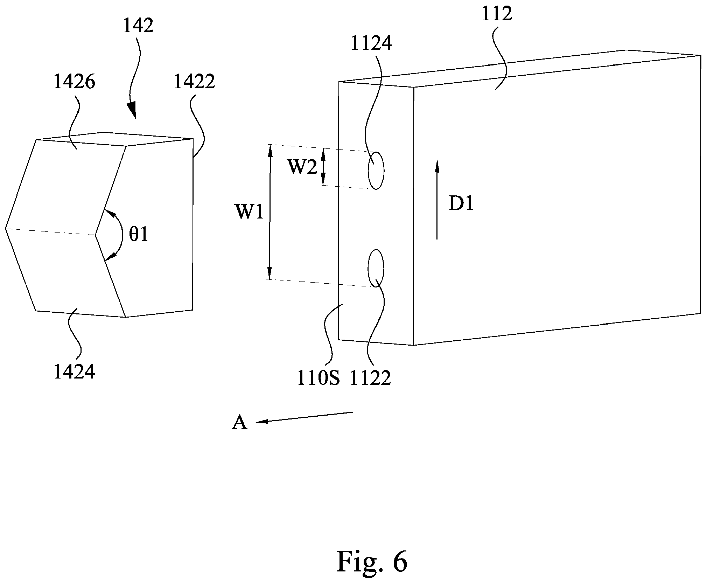

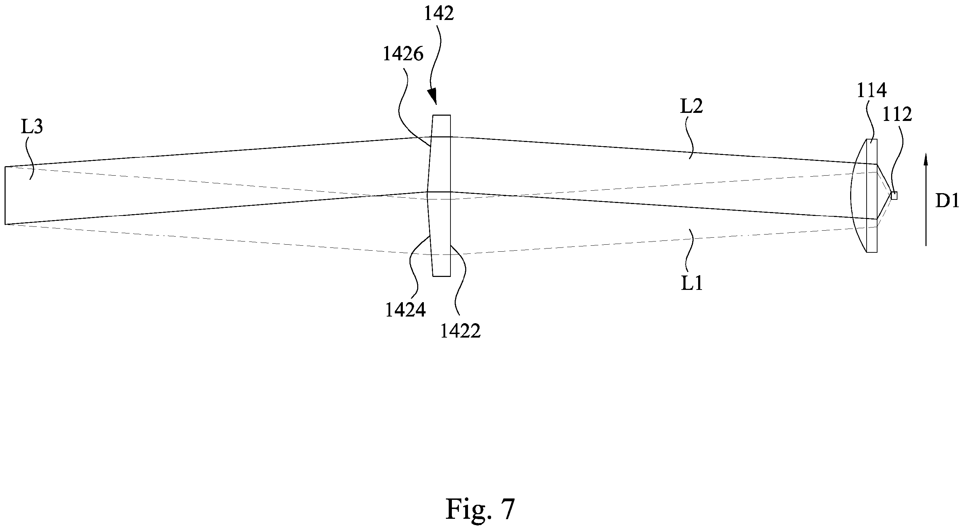

For clarity, the embodiment having only one first laser chip 112 accompanied with one wedge structure 142 will be described in detail firstly. Fig. 6 is a schematic of the first laser chip 112 and the wedge structure 142 according to one embodiment of the present disclosure. Fig. 7 is a light path schematic of the light beam from the first laser chip 112 passes through the wedge structure 142 in Fig. 6. Reference is made to Fig. 6 and Fig. 7. The focusing lens 114 is omitted in Fig. 6, and Fig. 7 is a side view.

The first laser chip 112 is a semiconductor laser chip of dual resonant cavities (dual emitter). The first laser chip 112 has a first resonant cavity 1122 and a second resonant cavity 1124 arranged along the first direction D1. The first direction D1 is perpendicular to the direction of optical axis A, and the first direction D1 is perpendicular to the normal direction of the light-emitting surface 110S. In the present embodiment, for example, the first direction D1 is a vertical direction. In other embodiment, the first resonant cavity 1122 and the second resonant cavity 1124 can be arranged along the horizontal direction.

A width W1 between the first resonant cavity 1122 and the second resonant cavity 1124 of the present embodiment is about 270 um, and an opening width W2 of the first resonant cavity 1122 and the second resonant cavity 1124 is about 75 um, but the present disclosure is not limited thereto.

The wedge structure 142 includes a first plane 1422, a first inclined surface 1424 and a second inclined surface 1426. The first plane 1422 faces the light-emitting surface 110S of the first laser chip 112. The first inclined surface 1424 and the second inclined surface 1426 are opposite to the first plane 1422 and face the plano-convex lens 150 (see Fig. 3). The first inclined surface 1424 and the second inclined surface 1426 have an angle $\theta 1$ therebetween.

As shown in Fig. 6 and Fig. 7, the first resonant cavity 1122 emits the first light beam L1, and the second resonant cavity 1124 emits the second light beam L2. The first light beam L1 and the second light beam L2 are red lights. The first light beam L1 and the second light beam L2 pass through the focusing lens 114 and travel towards the wedge structure 142.

The first light beam L1 and the second light beam L2 respectively pass through the first inclined surface 1424 and the second inclined surface 1426 after passing through the first plane 1422. Specifically, the first light beam L1 and the second light beam L2 deflect when pass though the wedge structure 142 due to the angle $\theta 1$ and the index of refraction. In the view potion in Fig. 7, the first light beam L1 deflects upward after passing through the first inclined surface 1424, and the second light beam L2 deflects downwards after passing through the second inclined surface 1426. In other words, the first light beam L1 deflects along the first direction D1 after passing through the first inclined surface 1424, the second light beam L2 deflects along the reversed direction of the first direction D1 after passing through the second inclined surface 1426. Accordingly, the first inclined surface 1424 and the second inclined surface 1426 are configured to refract the first light beam L1 and the second light beam L2 from the first laser chip 112 and makes them overlap each other to form a third light beam L3.

Material of the wedge structures 142 can be arbitrary transparent material that can refract light such as glass. Size of the wedge structure 142 is determined based on the size of the first laser chip 112. The angle $\theta 1$ of the wedge structure 142 can be changed according to the index of refraction difference and the distance between the wedge structure 142 and adjacent elements.

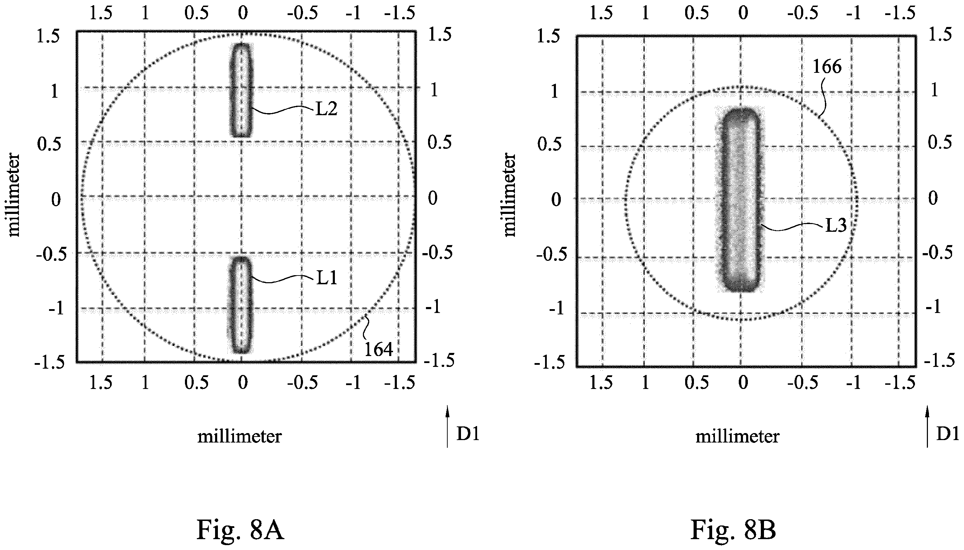

Figs. 8A and 8B are simulated images of the first light beam L1 and the second light beam L2 of the first laser chip 112. Simulated images of the first light beam L1 and the second light beam L2 without passing through the wedge structure 142 are illustrated in Fig. 8A. The circular dashed line indicates a light receiving range 164 of the light receiving surface 162 of the optical fiber 160 that is necessary to receive the first light beam L1 and the second light beam L2. Simulated images of the first light beam L1 and the second light beam L2 after passing through the wedge structure 142 are illustrated in Fig. 8B. The circular dashed line indicates a light receiving range 166 of the light receiving surface 162 of the optical fiber 160 that is necessary to receive the third light beam L3.

As shown in Fig. 8A, the first light beam L1 and the second light beam L2 travel to the light receiving surface 162 of the optical fiber 160 and form two light spots. A length of these two light spots in the first direction D1 is in a range from about 0.9 mm to 1.0 mm, and the distance between the two light spots in the first direction D1 is about 1.0 mm. A diameter of the light receiving range 164 of the light receiving surface 162 of the optical fiber 160 is about 2.9 mm.

As shown in Fig. 8B, since the first inclined surface 1424 and the second inclined surface 1426 can refract the first light beam L1 and the second light beam L2 and makes them overlap each other to form the third light beam L3, single light spot is formed on the light receiving surface 162 of the optical fiber 160. A length of the light spot in the first direction D1 is smaller than about 1.6 mm. Therefore, a diameter of the light receiving range 166 of the light receiving surface 162 of the optical fiber 160 can be reduced to about 1.6 mm.

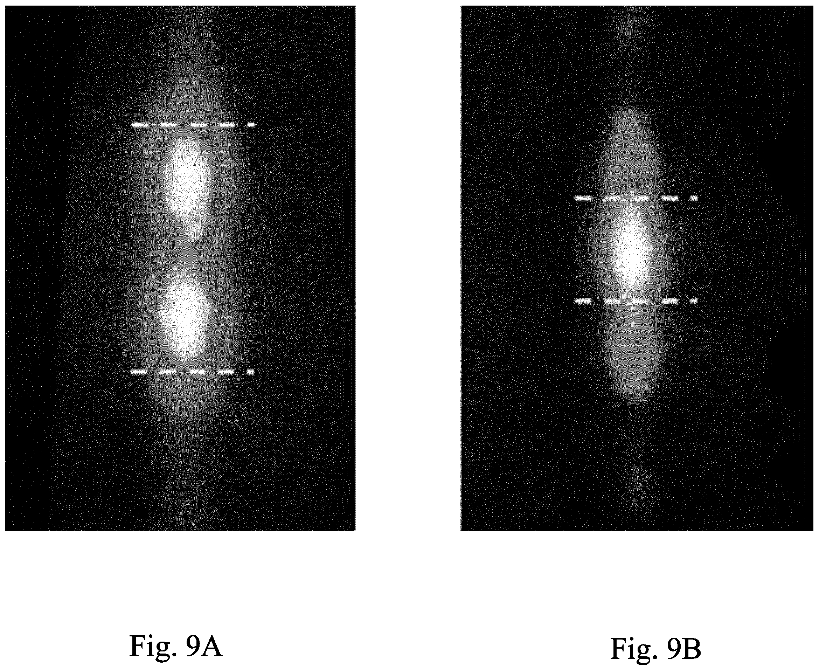

Figs. 9A and 9B are real images of the first light beam L1 and the second light beam L2 of the first laser chip 112. Real images of the first light beam L1 and the second light beam L2 without passing through the wedge structure 142 are illustrated in Fig. 9A. The first light beam L1 and the second light beam L2 form two light spots. A distance between the two dashed lines in Fig. 9A is about 3.6 mm. Real images of the third light beam L3 formed by the first light beam L1 and the second light beam L2 passed through the wedge structure 142 are illustrated in Fig. 9B. The third light beam L3 form a single light spot. The distance between the two dashed lines in Fig. 9B is reduced to about 1.6 mm.

According to Fig. 8A to Fig. 9B, the first inclined surface 1424 and the second inclined surface 1426 can refract the light beams from the dual resonant cavities of a single laser chip and make the light beams overlap each other to form a single light beam. As such, the light receiving range 166 of the light receiving surface 162 of the optical fiber 160 can be reduced to cut production cost. Such design enables the laser light source module 100 be applied in a projection system having small light receiving area such as the systems using fused optical bundle or small entry integration rod.

In addition, since the first laser array 110 is a semiconductor laser of dual resonant cavities (or multiple resonant cavities), output power of the red laser is enhanced. Therefore, the light receiving efficiency for red light won't degrade when the light receiving surface 162 reduces. The laser light source module 100 can reduce light receiving area, cut production cost and remain the light receiving efficiency simultaneously.

Reference is made to Fig. 2. In other embodiment, the second laser array 120 can include a single second laser chip 122 which is a semiconductor laser chip of single resonant cavity. In other embodiments, the third laser array 130 can include a single third laser chip 132 which is a semiconductor laser chip of single resonant cavity. In other words, configurations of the laser chips with different colors can be adjusted according to the required light emitting power.

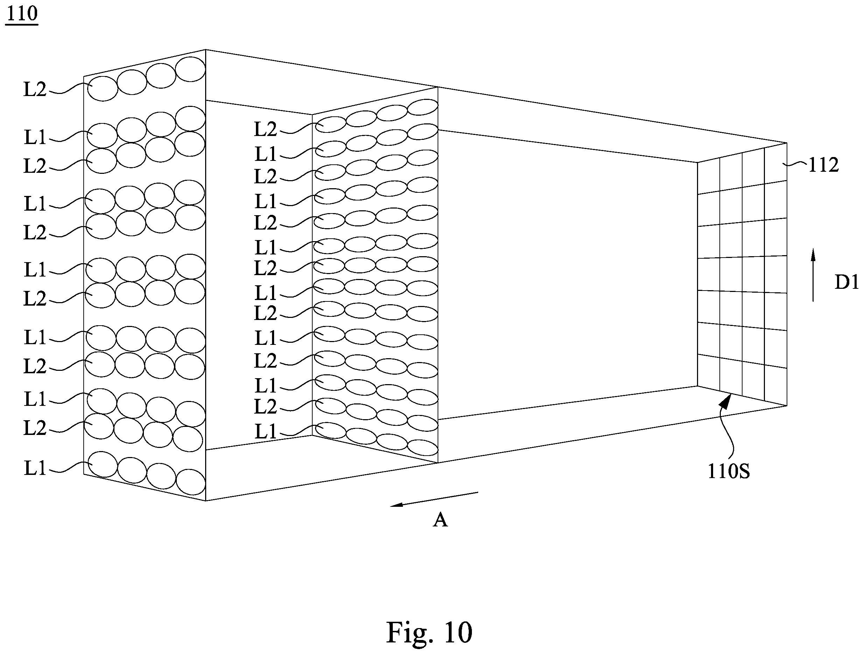

Fig. 10 is a light schematic of the first laser array 110 in Fig. 4. Reference is made to Fig. 4 and Fig. 10 simultaneously. The first laser chip 112 (the embodiment in Fig. 6) having dual resonant cavities is applied to the first laser array 110 shown in Fig. 4. Two cross sections of the two light spots are acquired in Fig. 10, and the light spots are used to describe the light beams herein.

Each of the first laser chips 112 of the first laser array 110 emits the first light beam L1 and the second light beam L2 arranged along the first direction D1. A distribution of the light spots in this embodiment has four columns and fourteen rows. The first light beam L1 and the second light beam L2 travel along the direction of the optical axis A, and the first light beam L1 and the second light beam L2 gradually expand and the sizes of the light spots gradually increase.

Reference is made to Fig. 5 and Fig. 10. The wedge structures 142 are repeatedly arranged along the first direction D1. There are seven rectangular first inclined surfaces 1424 and seven rectangular second inclined surfaces 1426 are alternately arranged along the first direction D1. In this embodiment, each one of the first inclined surfaces 1424 of the wedge structures 142 are configured to refract four first light beams L1 at the same row, and each one of the second inclined surfaces 1426 of the wedge structures 142 are configured to refract more four second light beams L2 at the same row. Therefore, 56 overlapped light beams from the first laser array 110 (28 first light beams L1 and 28 second light beams L2) by the wedge array 140 form 28 third light beams L3. Reference is made to Fig. 3, 28 third light beams L3 can be integrated as a single one fifth light beam L5 through the plano-convex lens 150 and enter the optical fiber 160.

Reference is made to Fig. 4 and Fig. 5 simultaneously. The concrete structures of each one of the first laser chips 112 in this embodiment are substantially the same, and therefore the angles θ1 of the first inclined surfaces 1424 and the second inclined surfaces 1426 of each one of the wedge structures 142 are the same. In other words, the angles θ1 of the wedge structures 142 are not correlated with the positions of the wedge structure 142 relative to the overall wedge array 140.

The angles θ1 of the wedge structures 142 are correlated with the radius of curvature of the plano-convex lens 150. For example, in the embodiment shown in Fig. 3, the numerical aperture (NA) of the optical fiber 160 is about 0.12. A maximum light receiving angle of the optical fiber 160 can be derived through the equation NA = n sin θ, which is about +/-12.7 degrees. Assume that a distance between the plano-convex lens 150 and the optical fiber 160 is about 113.4 mm, and a curvature of radius of the plano-convex lens 150 is about 85 mm derived from the equation

$$\frac{1}{f} = (n-1)(\frac{1}{r1} - \frac{1}{r2})$$
.

The distance between the wedge structure 142 and the first laser array 110 can be determined according to requirement or laser property. In this embodiment, the distance between the wedge structure 142 and the first laser array 110 is about 50 mm, and the distance between the plano-convex lens 150 and the wedge structure 142 is about 46 mm. Assumes that a distance between a center of the first light beam L1 and a center of the second light beam L2 is about 1.5 mm, the angle θ1 of the wedge structure 142 made with glass is about 1.8682 degrees through Snell's Law.

Accordingly, when the index of refraction of the wedge structure 142 is fixed, the larger the angle θ1 of the wedge structure 142 is, the larger the defection angle between the first light beam and the second light beam are. Therefore, the distance between the overlapping position of the light spots and the wedge structure 142 becomes shorter. When the angle θ1 of the wedge structure 142 is fixed, the larger the index of refraction of the wedge structure 142 is, the larger the defection angle between the first light beam and the second light beam are. Therefore, the distance between the overlapping position of the light spots and the wedge structure 142 becomes shorter.

Reference is made to Fig. 3. It is noted that the 28 first light beams L1 in Fig. 10 can be integrated as only one first light beam, and the 28 second light beams L2 can be integrated as only one second light beam when those light beams are merely focused by the plano-convex lens 150 without the wedge array 140. In other words, two separate light spots are formed when the lights are focused merely through the plano-convex lens 150. That is, the plano-convex lens 150 cannot make the light beams from the dual resonant cavities of the same laser chip overlap each other. Therefore, it is not sufficient to form a single light beam whose light spot is small enough to enter the light receiving surface 162 of the optical fiber 160 merely by using the plano-convex lens 150 as light focusing element.

In addition, if the positions of the plano-convex lens 150 and the wedge array 140 are exchanges, the 28 first light beams L1 will be focused as a light beam having a greater light spot through the plano-convex lens 150 first, and the 28 second light beams L2 will be focused as another light beam having a greater light spot. These two light beams separate from each other. Under such condition, it works poorly to refract the light beam formed by the integrated 28 first light beams L1 by one first inclined surface 1424 and to refract the light beam formed by the integrated 28 second light beams L2 by one second inclined surface 1426. In other words, since each one of the wedge structures 142 in the present disclosure directly refract the first light beam L1 and the second light beam L2 from the dual resonant cavities of single one laser chip, the light spots can overlap each other and the light receiving efficiency is improved.

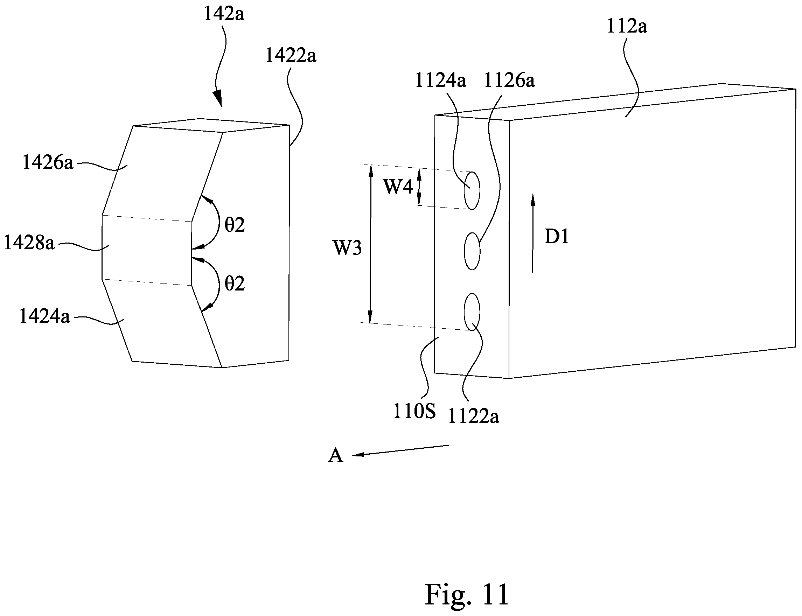

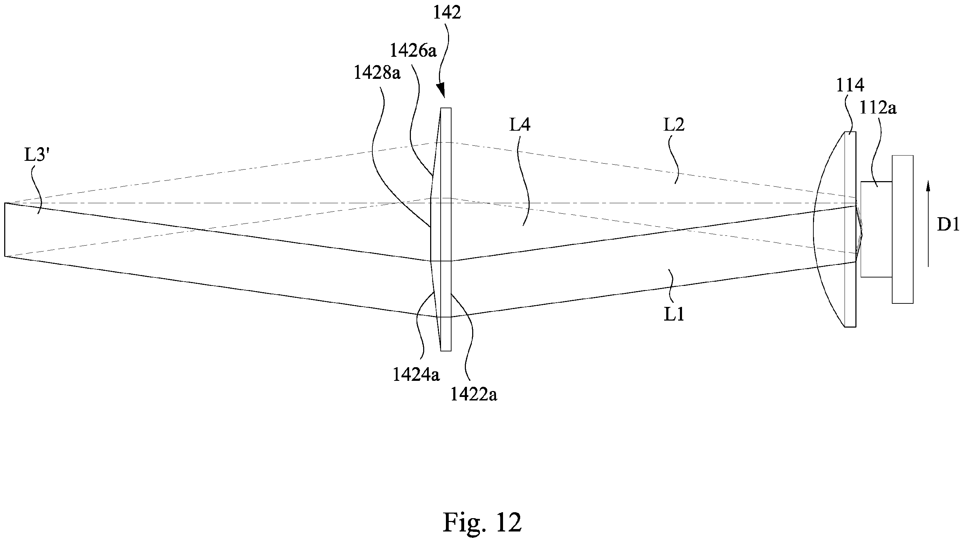

Fig. 11 is a schematic of the first laser chip 112a and the wedge structure 142a according to another embodiment of the present disclosure. Fig. 12 is a light path schematic of the light beam from the first laser chip 112a passing through the wedge structure 142a in Fig. 11. Reference is made to Fig. 11 and Fig. 12. The focusing lens 114 is omitted in Fig. 11. Fig. 12 is a side view.

The first laser chip 112a in the present embodiment is a semiconductor laser chip of three resonant cavities. The first laser chip 112a has a first resonant cavity 1122a, a third resonant cavity 1126a, and a second resonant cavity 1124a arranged along the first direction D1.

The wedge structures 142a are similar to the wedge structures 142 in Fig. 6, and the difference is that the wedge structures 142a further include second plane 1428a. The second plane 1428a connects the first inclined surface 1424a and the second inclined surface 1426a and is opposite to the first plane 1422a. The first inclined surface 1424a connects the second plane 1428a and have an angle θ2 therebetween. The second inclined surface 1426a connects the second plane 1428a and have an angle θ2 therebetween. The second plane 1428a faces the plano-convex lens 150 (see Fig. 3).

As shown in Fig. 11 and Fig. 12, the third resonant cavity 1126a emits a fourth light beam L4. The fourth light beam L4 passes through the second plane 1428a. The first light beam L1 and the second light beam L2 deflect and overlap each other when pass though the wedge structure 142a due to the angle θ2 and the index of refraction, and therefore another third light beam L3' formed. The first inclined surface 1424a of the wedge structure 142a is configured to refract the first light beam L1 along the first direction D1, and the second inclined surface 1426a is configured to refract the second light beam L2 along the reversed direction of the first direction D1. Specifically, the second plane is parallel with the first plane 1422a. The traveling direction of the fourth light beam L4 is parallel with the direction of the optical axis A, and the fourth light beam L4 does not deflect after passing through the wedge structure 142a.

A width W3 between the first resonant cavity 1122a and the second resonant cavity 1124a in the present embodiment is about 270 um. A width W4 of the openings of the first resonant cavity 1122a, the second resonant cavity 1124a, and the third resonant cavity 1126a is about 75 um, but the present disclosure are not limited thereto.

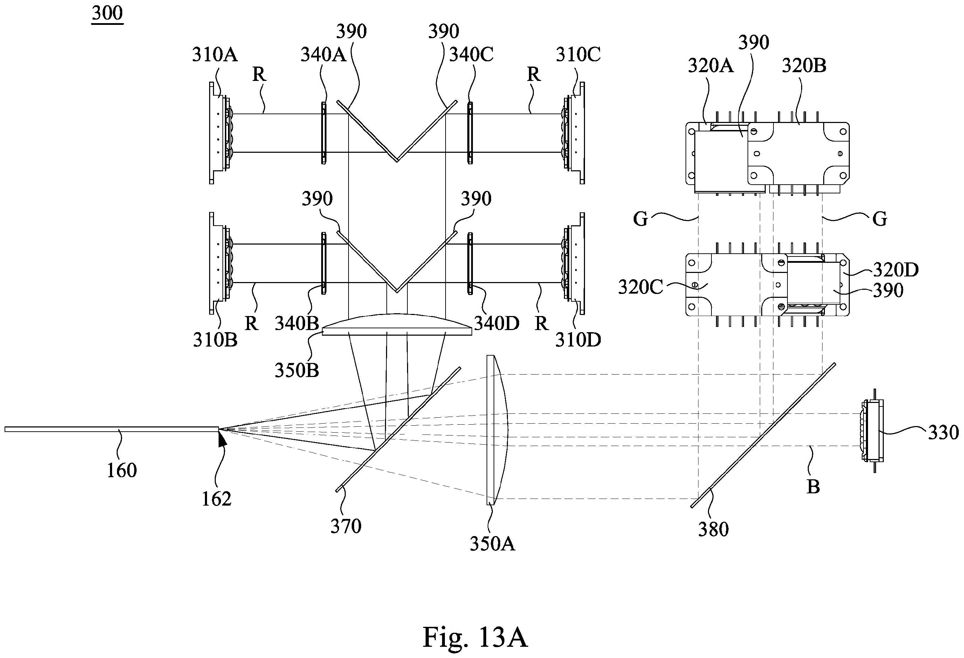

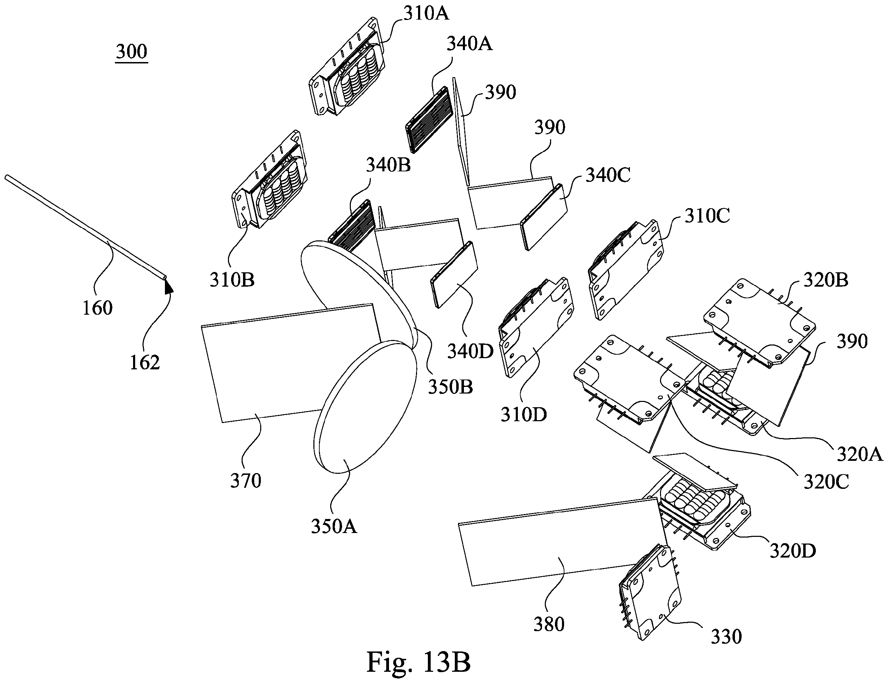

Figs. 13A and 13B are schematics of laser light source module 300 according to another embodiment of the present disclosure. The light paths of the laser light source module 300 are omitted in Fig. 13B. In the present embodiment, the laser light source module 300 includes four first laser arrays 310A, 310B, 310C, 3100, four second laser arrays 320A, 320B, 320C, 320D, and one third laser array 330. As described above, the first laser arrays 310A~310D are red semiconductor laser and have dual resonant cavities or multiple resonant cavities. The laser light source module 300 further includes four wedge arrays 340A, 340B, 340C, 340D, which respectively correspond to the four first laser arrays 310A~310D. The wedge arrays 340A~340D refract the light beams from the dual resonant cavities (or three resonant cavities) of the first laser arrays 310A~310D and make them overlap each other.

The laser light source module 300 further includes two plano-convex lenses 350A, 350B, an optical fiber 160, a first dichroic filter 370, a second dichroic filter 380, and multiple reflection mirrors 390. The blue lights B from the third laser array 330 are focused by the plano-convex lenses 350A. The red lights R from the first laser array 310A~310D that passed through the wedge arrays 340A~340D are focused by the plano-convex lenses 350B. The first dichroic filter 370 reflects the red lights R and enables transmittance of the blue lights B and the green lights G. The second dichroic filter 380 reflects the green lights G and enables transmittance of the blue lights B.

In general, blue laser chip has higher power due to better development level of the blue laser technique, and the red laser chip has lowest power. Therefore, the number of the third laser array 330 of the laser light source module 300 can less than the number of the first laser array 310A~310D and less than the number of the second laser array 320A~320D. The first laser chip 112 having multiple resonant cavities as shown in Fig. 6 are employed in the first laser array 310A~310D to raise red laser light power. Accordingly, laser light power of different colors in the laser light source module 300 can be balanced.

According to the embodiments above, the laser light sources each can include a single laser chip or a single laser array, and the arrangement method is not limited. A single laser chip is accompanied with a single wedge structure, and the laser arrays are accompanied with the wedge array. The arrangement method is not limited.

In summary, the first inclined surface and the second inclined surface of the wedge structure is configured to refract the light beams from the dual resonant cavities (or three resonant cavities) and make them overlap each other to form a single light beam. As such, the light receiving range of the light receiving surface of the optical fiber can be reduced to cut production cost. Such design enables the laser light source module be applied in a projection system having small light receiving area. In addition, since the first laser array is a dual resonant cavities (or multiple resonant cavities) semiconductor laser, output power of the red laser is enhanced. Therefore, the light receiving efficiency for red light won't degrade when the light receiving surface reduces. The laser light source module can reduce light receiving area, cut production cost and remain the light receiving efficiency simultaneously.

**Claims**

1. A laser light source module (100, 300), comprising:

   at least one laser chip (112, 112a, 122, 132) configured to emit a first light beam (L1) and a second light beam (L2);
   at least one wedge structure (142, 142a) configured to refract the first light beam (L1) and the second light beam (L2) and make the first light beam (L1) and the second light beam (L2) overlap each other to form a third light beam (L3);
   a plano-convex lens (150, 350A, 350B), wherein the wedge structure (142, 142a) is located between the laser chip (112, 112a, 122, 132) and the plano-convex lens (150, 350A, 350B); and
   an optical fiber (160), wherein the plano-convex lens (150, 350A, 350B) is located between the wedge structure (142, 142a) and the optical fiber (160).

2. The laser light source module of claim 1, wherein the laser chip (112, 112a, 122, 132) is a red semiconductor laser chip of multiple resonant cavities.

3. The laser light source module of one of the claims 1-2, wherein the optical fiber (160) comprises a light receiving surface (162), the plano-convex lens (150, 350A, 350B) is configured to focus the third light beam (L3) from the wedge structure (142, 142a) to form a fifth light beam (L5), and the light receiving surface (162) is configured to receive the fifth light beam (L5).

4. The laser light source module of one of the claims 1-3, wherein the laser chip (112, 112a, 122, 132) comprises a light-emitting surface (110S), a first resonant cavity (1122, 1122a), and a second resonant cavity (1124, 1124a), the first resonant cavity (1122, 1122a) emits the first light beam (L1), the second resonant cavity (1124, 1124a) emits the second light beam (L2), the wedge structure (142, 142a) comprises a first plane (1422, 1422a), a first inclined surface (1424, 1424a), and a second inclined surface (1426, 1426a), the first plane (1422, 1422a) faces the light-emitting surface (110S) of the laser chip (112, 112a, 122, 132), the first inclined surface (1424, 1424a) and the second inclined surface (1426, 1426a) face the plano-convex lens (150, 350A, 350B) and are opposite to the first plane (1422, 1422a), and the first light beam (L1) and the second light beam (L2) pass through the first inclined surface (1424, 1424a) and the second inclined surface (1426, 1426a), respectively.

5. The laser light source module of claim 4, wherein the laser chip (112, 112a, 122, 132) further comprises a third resonant cavity (1126a) located between the first resonant cavity (1122, 1122a) and the second resonant cavity (1124, 1124a), the third resonant cavity (1126a) emits a fourth light beam (L4), the wedge structure (142, 142a) comprises a second plane (1428a), the second plane (1428a) connects the first inclined surface (1424, 1424a) and the second inclined surface (1426, 1426a) and is opposite to the first plane (1422, 1422a), the fourth light beam (L4) passes through the second plane (1428a), and the first inclined surface (1424, 1424a) and the second inclined surface (1426, 1426a) of the wedge structure (142, 142a) are configured to refract the first light beam (L1) and the second light beam (L2) towards the fourth light beam (L4) and make the first light beam (L1) and the second light beam (L2) to overlap each other.

6. The laser light source module of one of the claims 4-5, wherein a number of the at least one laser chip (112, 112a, 122, 132) is plural, a number of the at least one wedge structure (142, 142a) is plural, the wedge structures (142, 142a) correspond to the laser chips (112, 112a, 122, 132) respectively, the laser chips (112, 112a, 122, 132) form at least one laser array (110, 120, 130, 310A~310D, 320A~320D, 330), and the wedge structures (142, 142a) form at least one wedge array (140, 340A-340D).

7. The laser light source module of claim 6, wherein the wedge structures (142, 142a) of the wedge array (140, 340A-340D) are connected together.

8. The laser light source module of one of the claims 6-7, wherein each one of the laser chips (112, 112a, 122, 132) comprises the first resonant cavity (1122, 1122a) and the second resonant cavity (1124, 1124a) arranged along a first direction (D1), the first inclined surfaces (1424, 1424a) and the second inclined surfaces (1426, 1426a) of the wedge structures (142, 142a) are alternately arranged along the first direction (D1), each one of the first inclined surfaces (1424, 1424a) of the wedge structures (142, 142a) is configured to refract more than one of the first light beams (L1), and each one of the second inclined surfaces (1426, 1426a) of the wedge structures (142, 142a) is configured to refract more than one of the second light beams (L2).

9. The laser light source module of claim 8, wherein the first inclined surface (1424, 1424a) and the second inclined surface (1426, 1426a) of each one of the wedge structures (142, 142a) have an angle (θ1) therebetween, and the angles (θ1) of the wedge structures (142, 142a) are the same.

10. A projection apparatus (10), comprising:

a laser light source module (100, 300), comprising:

at least one first laser chip (112, 112a), at least one second laser chip (122), and at least one third laser chip (132), wherein the first laser chip (112, 112a) is configured to emit a first light beam (L1) and a second light beam (L2);
at least one wedge structure (142, 142a) configured to refract the first light beam (L1) and the second light beam (L2) into a third light beam (L3) and make the first light beam (L1) and the second light beam (L2) overlap each other; and
a plano-convex lens (150, 350A, 350B), wherein the wedge structure (142, 142a) is located between the first laser chip (112, 112a) and the plano-convex lens (150, 350A, 350B); and

a projection module (200) connecting the laser light source module (100).

11. The projection apparatus of claim 10, wherein the laser light source module (100) further comprises an optical fiber (160), and the plano-convex lens (150, 350A, 350B) is located between the wedge structure (142, 142a) and the optical fiber (160).

12. The projection apparatus of one of the claims 10-11, wherein the first laser chip (112, 112a), the second laser chip (122), and the third laser chip (132) are semiconductor lasers and are configured to emit laser lights with different wavelengths.

13. The projection apparatus of one of the claims 10-12, wherein the first laser chip (112, 112a) is a semiconductor laser chip of multiple resonant cavities, and the second laser chip (122) and the third laser chip (132) are semiconductor laser chips of single resonant cavity.

14. The projection apparatus of one of the claims 10-13, wherein the first laser chip (112, 112a) is a red semiconductor laser chip, and the first laser chip (112, 112a) comprises a light-emitting surface (110S), a first resonant cavity (1122, 1122a), and a second resonant cavity (1124, 1124a), the first resonant cavity (1122, 1122a) emits the first light beam (L1), the second resonant cavity (1124, 1124a) emits the second light beam (L2), the wedge structure (142, 142a) comprises a first plane (1422, 1422a), a first inclined surface (1424, 1424a), and a second inclined surface (1426, 1426a), the first plane (1422, 1422a) faces the light-emitting surface (110S) of the first laser chip (112, 112a), the first inclined surface (1424, 1424a) and the second inclined surface (1426, 1426a) face the plano-convex lens (150, 350A, 350B) and are opposite to the first plane (1422, 1422a), and the first light beam (L1) and the second light beam (L2) pass through the first inclined surface (1424, 1424a) and the second inclined surface (1426, 1426a), respectively.

15. The projection apparatus of claim 14, wherein the first laser chip (112, 112a) further comprises a third resonant cavity (1126a) located between the first resonant cavity (1122, 1122a) and the second resonant cavity (1124, 1124a), the third resonant cavity (1126a) emits a fourth light beam (L4), the wedge structure (142, 142a) further comprises a second plane (1428a), the second plane (1428a) connects the first inclined surface (1424, 1424a) and the second inclined surface (1426, 1426a) and are opposite to the first plane (1422, 1422a), the fourth light beam (L4) passes through the second plane (1428a), and the first inclined surface (1424, 1424a) and the second inclined surface (1426, 1426a) of the wedge structure (142, 142a) are configured to respectively refract the first light beam (L1) and the second light beam (L2) towards the fourth light beam (L4) and make the first light beam (L1) and the second light beam (L2) overlap each other.

16. The projection apparatus of one of the claims 14-15, wherein a number of the at least one first laser chip (112, 112a) is plural, a number of the at least one wedge structure (142, 142a) is plural, the wedge structures (142, 142a) correspond to the first laser chips (112, 112a) respectively, the first laser chips (112, 112a) form at least one laser array (110, 310A~310D), and the wedge structures (142, 142a) form at least one wedge array (140, 340A-340D).

17. The projection apparatus of claim 16, wherein each one of the first laser chips (112, 112a) comprises the first resonant cavity (1122, 1122a) and the second resonant cavity (1124, 1124a) arranged along a first direction (D1), the first inclined surfaces (1424,1424a) and the second inclined surfaces (1426, 1426a) of the wedge structures (142, 142a) are alternately arranged along the first direction (D1), each one of the first inclined surfaces (1424,1424a) of the wedge structures (142, 142a) are configured to refract more than one of the first light beams (L1), and each one of the second inclined surfaces (1426, 1426a) of the wedge structures (142, 142a) are configured to refract more than one of the second light beams (L2).

18. The projection apparatus of claim 17, wherein the first inclined surface (1424,1424a) and the second inclined surface (1426, 1426a) of each one of the wedge structures (142, 142a) have an angle ($\theta1$) therebetween, and the angles ($\theta1$) of the wedge structures (142, 142a) are the same.

19. The projection apparatus of one of the claims 17-18, wherein a number of the second laser chip (122) is plural, the second laser chips (122) form a plurality of second laser array (120, 320A~320D), a number of the at least one third laser chip (132) is plural, the third laser chips (132) form a third laser array (130, 330), the first laser chips (112, 112a) are red semiconductor laser chips, the second laser chips (122) are green semiconductor laser chips, and the third laser chips (132) are blue semiconductor laser chips.

Fig. 1

Fig. 2

EP 4 498 537 A1

Fig. 3

EP 4 498 537 A1

Fig. 4

EP 4 498 537 A1

Fig. 5

Fig. 6

EP 4 498 537 A1

Fig. 7

EP 4 498 537 A1

Fig. 8A

Fig. 8B

EP 4 498 537 A1

Fig. 9A

Fig. 9B

Fig. 10

EP 4 498 537 A1

EP 4 498 537 A1

142a

1422a

1426a

1428a

θ2

θ2

1424a

1124a 1126a

112a

W4

W3

D1

110S 1122a

A ←

Fig. 11

Fig. 12

EP 4 498 537 A1

Fig. 13A

Fig. 13B

Europäisches Patentamt

European Patent Office

Office européen des brevets

# EUROPEAN SEARCH REPORT

**Application Number**

EP 24 15 6479

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/285619 A1 (NISHIMOTO MASAHIKO [JP] ET AL) 16 September 2021 (2021-09-16) <br> * paragraphs [0001] - [0008], [0154] - [0187], [0219] - [0253], [0280]; figures 6-9, 14 * <br> ----- | 1-19 | INV. <br> H01S5/00 <br> G02B6/42 <br> G02B27/09 <br> G02B27/10 <br> G02B27/18 |
| A | US 2023/121969 A1 (KANAZAWA TATSUYA [JP] ET AL) 20 April 2023 (2023-04-20) <br><br> * paragraphs [0001] - [0135]; figures 1-16 * <br><br> ----- | 2,6-9, 12,13, 16-19 | |
| A | US 2015/316234 A1 (SAMONJI KATSUYA [JP] ET AL) 5 November 2015 (2015-11-05) <br><br> * paragraphs [0001] - [0105]; figures 1-15 * <br><br> ----- | 2,6-9, 12,13, 16-19 | |
| A | US 2016/029001 A1 (JANNARD JAMES H [US] ET AL) 28 January 2016 (2016-01-28) <br><br> * paragraphs [0114] - [0186]; figures 1-15 * <br><br> ----- | 2,6-9, 12,13, 16-19 | **TECHNICAL FIELDS SEARCHED (IPC)** <br><br> H01S <br> G02B |

The present search report has been drawn up for all claims

| Place of search | Date of completion of the search | Examiner |
|---|---|---|
| Munich | 25 July 2024 | Wolf, Steffen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 6479

This annex lists the patent family members relating to the patent documents cited in the above-mentioned European search report.
The members are as contained in the European Patent Office EDP file on
The European Patent Office is in no way liable for these particulars which are merely given for the purpose of information.

25-07-2024

| Patent document cited in search report | Publication date | Patent family member(s) | Publication date |
|---|---|---|---|
| US 2021285619 A1 | 16-09-2021 | CN 113165115 A | 23-07-2021 |
| | | JP 7410875 B2 | 10-01-2024 |
| | | JP WO2020116084 A1 | 04-11-2021 |
| | | US 2021285619 A1 | 16-09-2021 |
| | | WO 2020116084 A1 | 11-06-2020 |
| US 2023121969 A1 | 20-04-2023 | CN 115995755 A | 21-04-2023 |
| | | JP 2023061241 A | 01-05-2023 |
| | | US 2023121969 A1 | 20-04-2023 |
| US 2015316234 A1 | 05-11-2015 | JP 6178991 B2 | 16-08-2017 |
| | | JP WO2014115194 A1 | 19-01-2017 |
| | | US 2015316234 A1 | 05-11-2015 |
| | | WO 2014115194 A1 | 31-07-2014 |
| US 2016029001 A1 | 28-01-2016 | CN 104272728 A | 07-01-2015 |
| | | EP 2842330 A1 | 04-03-2015 |
| | | ES 2688819 T3 | 07-11-2018 |
| | | JP 6275116 B2 | 07-02-2018 |
| | | JP 2015519597 A | 09-07-2015 |
| | | US 2013300948 A1 | 14-11-2013 |
| | | US 2015042895 A1 | 12-02-2015 |
| | | US 2016029001 A1 | 28-01-2016 |
| | | US 2016366381 A1 | 15-12-2016 |
| | | US 2018184057 A1 | 28-06-2018 |
| | | WO 2013155319 A1 | 17-10-2013 |

EPO FORM P0459

For more details about this annex : see Official Journal of the European Patent Office, No. 12/82